# EUROPEAN PATENT APPLICATION

(11) **EP 4 496 167 A1**
(43) Date of publication of application: **22.01.2025**
(21) Application number: 24157006.8
(22) Date of filing: 12.02.2024
(51) Int. Cl.: H02J 3/32, H01M 10/42, H01M 10/44, H02J 7/00

(54) **OPERATION METHOD, OPERATION DEVICE AND OPERATION PROGRAM OF POWER STORAGE SYSTEM, AND POWER STORAGE SYSTEM**

(30) Priority: 18.07.2023 JP 2023116974
(71) Applicant: Kabushiki Kaisha Toshiba, Tokyo 105-0023 (JP)
(72) Inventor: FUJITA, Yumi, Tokyo 105-0023 (JP); MORITA, Tomokazu, Tokyo 105-0023 (JP); ZHANG, Wen, Tokyo 105-0023 (JP); MIYAZAKI, Shoko, Tokyo 105-0023 (JP); SUGIYAMA, Nobukatsu, Tokyo 105-0023 (JP)
(74) Representative: Marks & Clerk LLP

(57) **Abstract**

In an approach, in an operation method of a power storage system (1), a plurality of SOC ranges (X) shifted from each other are set, and one of the SOC ranges (X) to be an option is selected as an operation SOC range for each of a plurality of groups (Y) so as to be in a state where the SOC ranges (X) selected are different between the groups (Y). In the operation method, a power storage facility (3) belonging to each of the groups (Y) is operated in the SOC range (X) selected as the operation SOC range, and the SOC range (X) to be selected as the operation SOC range is sequentially switched between the plurality of SOC ranges (X) for each of the groups (Y) so as to be in a state in where the SOC ranges (X) selected are different between the groups (Y).

## Description

### FIELD

Disclosures described herein relate generally to an operation method, an operation device and an operation program of a power storage system, and the power storage system.

### BACKGROUND

In a power storage station or the like, a power storage system including a plurality of power storage facilities is used. In the power storage system, each of the plurality of power storage facilities includes one or more batteries, and the plurality of power storage facilities can exchange electric power through the power grid independently from each other. In the power storage system, each of the plurality of power storage facilities is operated by exchanging electric power with a power storage device, a generator, a load device, and the like outside the power storage system through a power grid.

In the power storage system, each of the plurality of power storage facilities is charged and discharged in an SOC range whose SOC width is relatively small, such as a range whose SOC width is 50% or less, depending on a usage mode or the like. When charging and discharging of the power storage facility are repeatedly performed only in a specific SOC range whose SOC width is relatively small, the progress of deterioration of the power storage facility and the battery used in the power storage facility may be accelerated depending on the type of the electrode active material used for the battery of the power storage facility. In the operation of the power storage system, it is required to appropriately reduce the progress of deterioration of each power storage facility even in a usage mode in which each power storage facility is charged and discharged in an SOC range whose SOC width is relatively small. In a usage mode in which each of the plurality of power storage facilities is charged and discharged in an SOC range whose SOC width is relatively small, it is required that the power storage system is appropriately operated while appropriately reducing the progress of deterioration of the power storage facility. For example, it is required to appropriately operate the power storage system in a state where the charge reserve and the discharge reserve of the entire power storage system are secured at any timing.

### BRIEF DESCRIPTION OF DRAWINGS

FIG. 1 is a block diagram schematically showing an example of a power storage system according to an approach.
FIG. 2 is a schematic diagram illustrating an example of a plurality of SOC ranges set by a processing circuit of the operation device in the approach.
FIG. 3 is a schematic diagram illustrating an example of a switching process for switching an SOC range selected as an operation SOC range for each of a plurality of groups, the switching process being performed by a processing circuit of the operation device in the approach.
FIG. 4 is a schematic diagram illustrating a temporal change in the SOC range selected as the operation SOC range in each of the plurality of groups in the switching process of an example of FIG. 3.
FIG. 5 is a flowchart schematically illustrating an example of processing in the operation of the power storage system performed by the processing circuit of the operation device in the approach and the like.
FIG. 6 is a schematic diagram showing a temporal change in the capacity retention ratio of the battery capacity of the battery in each of Comparative Example, Example 1, and Example 2 as a verification result.

### DETAILED DESCRIPTION

In the approach, in the operation method of the power storage system including the plurality of power storage facilities, the method includes grouping the plurality of power storage facilities into a plurality of groups, and setting the plurality of SOC ranges shifted from each other as an option of the operation SOC range of each of the plurality of groups. The operation method includes selecting one of the plurality of SOC ranges to be the option as the operation SOC range for each of the plurality of groups so as to be in a state in which the SOC ranges selected are different between the plurality of groups, and operating the power storage facility belonging to each of the plurality of groups in the SOC range selected as the operation SOC range. The operation method includes sequentially switching the SOC range to be selected as the operation SOC range between the plurality of SOC ranges for each of the plurality of groups so as to be in a state in which the SOC ranges selected are different between the plurality of groups.

Hereinafter, approaches and the like will be described with reference to the drawings.

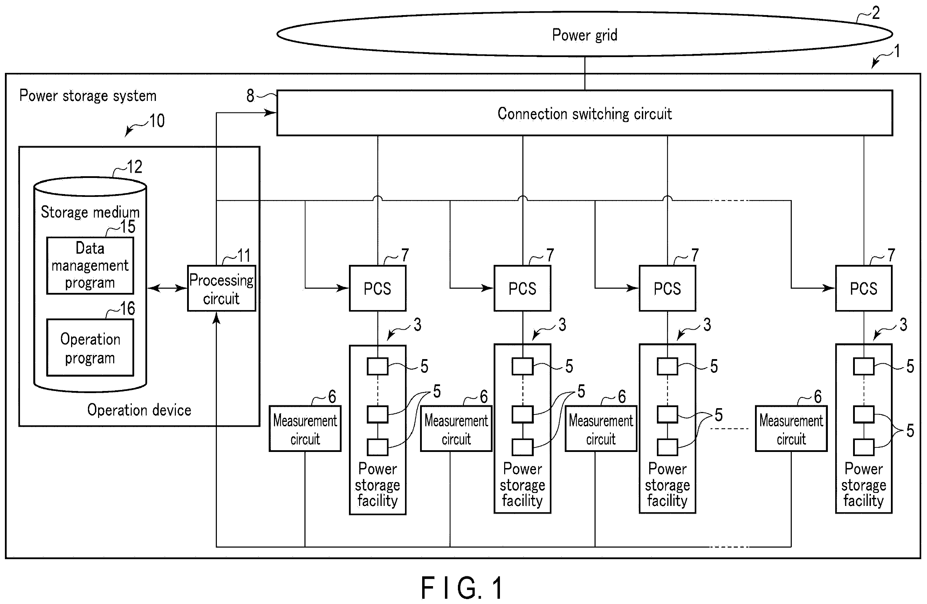

FIG. 1 illustrates an example of a power storage system 1 according to an approach. The power storage system 1 is used in a power storage station or the like, and is, for example, a large-sized power storage system for a power grid. The power storage system 1 can be connected to a power grid 2, and can exchange electric power with a device (not shown) outside the power storage system 1 through the power grid 2. Examples of the power grid 2 include a power grid that supplies electric power from a generator that generates electric power using natural energy such as sunlight and wind electric power, and a power grid that supplies electric power from an electric power plant. Examples of the device that exchanges electric power with the power storage system 1 through the power grid 2 include a power storage device, a generator, and a load device. In an example, electric power from a generator that generates electric power using natural energy is stored in the power storage system 1 through the power grid 2. Then, the power storage system 1 supplies the stored electric power to an external power storage device, a load device, and the like through the power grid 2.

The power storage system 1 includes a plurality of power storage facilities 3. The plurality of power storage facilities 3 can exchange electric power through the power grid 2 independently from each other. That is, the plurality of power storage facilities 3 can be independently connected to the power grid 2. Each of the plurality of power storage facilities 3 includes one or more batteries 5, and in an example of FIG. 1, the plurality of batteries 5 is electrically connected to each other in each of the plurality of power storage facilities 3. In each of the power storage facilities 3, the plurality of batteries 5 may be electrically connected in series or electrically connected in parallel. In each of the power storage facilities 3, both a structure in which a plurality of batteries 5 is electrically connected in series and a structure in which a plurality of batteries 5 is electrically connected in parallel may be configured.

Each of the batteries 5 is, for example, a secondary battery such as a lithium ion secondary battery. In an example, in each of the power storage facilities 3, each of the one or more batteries 5 is constituted by a battery module. In each of the plurality of battery modules, a plurality of battery cells (unit cells) is electrically connected. In each of the battery modules, a plurality of battery cells may be electrically connected in series, or a plurality of battery cells may be electrically connected in parallel. In each of the battery modules, both a structure in which a plurality of battery cells is electrically connected in series and a structure in which a plurality of battery cells is electrically connected in parallel may be formed.

In each of the power storage facilities 3, each of the one or more batteries 5 includes a positive electrode active material and a negative electrode active material as electrode active materials. In an example of the approach, lithium iron phosphate (LFP) is used as the positive electrode active material of each of the batteries 5. In this case, as the negative electrode active material of each of the batteries 5, for example, any of a carbonaceous material, a titanium-containing oxide, a silicon-based negative electrode material, and the like, or a mixed material thereof is used.

In each of the power storage facilities 3, an amount of charge (charge level) and an SOC value are defined as parameters indicating a state of charge. Then, for each of the power storage facilities 3, the amount of charge in real time is calculated based on the amount of charge at a predetermined time point, a temporal change in current from the predetermined time point, and the like. For example, for each of the power storage facilities 3, the amount of charge in real time is calculated by adding the time integrated value of the current from a predetermined time point to the amount of charge at the predetermined time point.

In each of the power storage facilities 3, a lower limit voltage Vmin and an upper limit voltage Vmax are defined for the voltage. In each of the power storage facilities 3, a state in which the voltage in discharging or charging under a predetermined condition is the lower limit voltage Vmin is defined as a state in which the SOC value is 0%, and a state in which the voltage in discharging or charging under a predetermined condition is the upper limit voltage Vmax is defined as a state in which the SOC value is 100%. In each of the power storage facilities 3, a charge capacity (amount of charge) until the SOC value changes from 0% to 100% in charging under a predetermined condition, or a discharge capacity (amount of discharge) until the SOC value changes from 100% to 0% in discharging under a predetermined condition is defined as the battery capacity. For each of the power storage facilities 3, the ratio of the residual amount of charge (residual capacity) until the SOC value is 0% with respect to the battery capacity is the SOC value.

Since the SOC value of each of the power storage facilities 3 is defined as described above, the SOC value of each of the power storage facilities 3 can be calculated in real time in a state where the operation is performed by charging, discharging, or the like. For each of the power storage facilities 3, it is also possible to calculate the SOC value in real time from the open circuit voltage in real time of the power storage facility 3 based on the relationship between the open circuit voltage and the SOC value of the power storage facility 3.

In each of the power storage facilities 3, the amount of charge (charge level) and the SOC value are also defined as parameters indicating the state of charge for each of the one or more batteries 5 provided in the power storage facility 3. In each of the batteries 5, the amount of charge and the SOC value are defined as in the power storage facility 3. For each of the batteries 5, the amount of charge and the SOC value in real time can be calculated in the same manner as the calculation of the amount of charge and the SOC value in the power storage facility 3.

The power storage system 1 of an example of FIG. 1 includes measurement circuits 6 the number of which is the same as the number of the power storage facilities 3 are provided, and one measurement circuit 6 is provided for each of the power storage facilities 3. Each of the measurement circuits 6 measures a parameter related to the corresponding one of the power storage facilities 3. For example, each of the measurement circuits 6 measures current and voltage of the corresponding one of the power storage facilities 3. In addition, each of the measurement circuits 6 may measure temperature of the corresponding one of the power storage facilities 3. Therefore, each of the measurement circuits 6 may include a current measurement circuit that measures current and a voltage measurement circuit that measures voltage, and may include a temperature sensor that measures temperature, and the like. Each of the measurement circuits 6 may measure any of the current, the voltage, and the temperature of each of one or more batteries 5 for the corresponding one of the power storage facilities 3.

Each of the measurement circuits 6 periodically measures a parameter related to a corresponding one of the power storage facilities 3, such as a current or a voltage as the corresponding one of the power storage facilities 3. Therefore, as a measurement result in each of the measurement circuits 6, it is possible to acquire a temporal change in a parameter related to the corresponding one of the power storage facilities 3, and for example, it is possible to acquire a temporal change (time history) in each of the current and the voltage as the corresponding one of the power storage facilities 3. When the battery 5 includes a plurality of battery cells in series connection in each of the power storage facilities 3, a cell balancer for adjusting an SOC difference between the plurality of battery cells may be introduced to each of the power storage facilities 3 together with the measurement circuit 6.

In each of the power storage facilities 3, when the battery 5 has a configuration in which a plurality of battery cells is connected in parallel and the parallel battery cells connected in parallel are connected in series, a cell balancer for adjusting an SOC difference between the plurality of parallel battery cells may be introduced together with the measurement circuit 6 to each of the power storage facilities 3.

The power storage system 1 includes electric power conditioning subsystems 7 (PCSs), as the bidirectional electric power converters, the number of which is the same as the number of the power storage facilities 3, and one PCS 7 is provided for each of the power storage facilities 3. Each of the PCSs 7 converts electric power from the power grid 2 and inputs the converted electric power to the corresponding one of the power storage facilities 3. At this time, each of the PCSs 7 converts, for example, AC electric power from the power grid 2 into DC electric power in a voltage range corresponding to the power storage facility 3 by AC/DC conversion and transformation, and inputs the converted DC electric power to the corresponding one of the power storage facilities 3. Each of the power storage facilities 3 is charged by electric power being input through a corresponding one of the PCSs 7.

Each of the PCSs 7 converts electric power from the corresponding one of the power storage facilities 3 to output the converted electric power to the power grid 2. At this time, each of the PCSs 7 converts, for example, DC electric power from a corresponding one of the power storage facilities 3 into AC electric power in a voltage range and a frequency range corresponding to the power grid 2 by DC/AC conversion and transformation to output the converted AC electric power to the power grid 2. Each of the power storage facilities 3 is discharged by outputting electric power through one corresponding PCS 7.

In addition, the power storage system 1 includes a connection switching circuit 8. The connection switching circuit 8 is provided between each of the PCSs 7 and the power grid 2, and can switch an electrical connection state of each of the power storage facility 3 to the power grids 2. The connection switching circuit 8 can switch an electrical connection state with respect to the power grid 2 for each power storage facility 3. As a result, the plurality of power storage facilities 3 can exchange electric power independently through the power grid 2.

In addition, since the electrical connection state to the power grid 2 can be switched for each power storage facility 3, in the power storage system 1, the connection switching circuit 8 can form a state in which one power storage facility 3 is electrically connected to the power grid 2 and another power storage facility 3 is not electrically connected to the power grid 2. In addition, the connection switching circuit 8 can switch an electrical connection state of each of the power storage facilities 3 to another power storage facility 3 of the power storage system 1. The power storage system 1 can exchange electric power between the plurality of power storage facilities 3 electrically connected by the connection switching circuit 8.

The power storage system 1 includes an operation device 10. The operation device 10 performs processing related to the operation of the power storage system 1, and performs, for example, control of charge and discharge of each of the plurality of power storage facilities 3, management of an operation SOC range which is an SOC range to be operated for each of the power storage facilities 3, and the like. In an example, the operation device 10 is a processing device (computer) such as a server, and includes a processing circuit 11 and a storage medium (non-transitory storage medium) 12. The processing circuit 11 includes a processor, an integrated circuit, or the like, and the processor or the like constituting the processing circuit 11 includes any of a central processing unit (CPU), an application specific integrated circuit (ASIC), a microcomputer, a field programmable gate array (FPGA), a digital signal processor (DSP), and the like. The processing circuit 11 may include one processor or the like, or may include a plurality of processors or the like. The storage medium 12 is either a main storage device such as a memory or an auxiliary storage device. The operation device 10 may include only one memory or the like serving as the storage medium 12, or may include a plurality of memories or the like.

The processing circuit 11 performs processing by executing a program or the like stored in the storage medium 12. In an example of FIG. 1, the storage medium (non-transitory storage medium) 12 stores a data management program 15 and an operation program 16 as programs to be executed by the processing circuit 11. The processing circuit 11 executes the data management program 15 to write data to the storage medium 12 and read data from the storage medium 12. In addition, the processing circuit 11 executes the operation program 16 to perform processing described later related to the operation of the power storage system 1. In addition, in a case where the operation device 10 is a processing device such as a server, the processing circuit 11 may be activated by converting electric power from the power grid 2 by the PCS or the like and supplying the converted electric power to the processing circuit 11.

In an example, the operation device 10 includes a plurality of processing devices (computers) such as a plurality of servers, and the processors of the plurality of processing devices cooperate to perform processing to be described later related to the operation of the power storage system 1. In another example, the operation device 10 is a cloud server in a cloud environment. The infrastructure of the cloud environment includes a virtual processor such as a virtual CPU and a cloud memory. Therefore, in a case where the operation device 10 is a cloud server, the virtual processor performs processing described later related to the operation of the power storage system 1 instead of the processing circuit 11. The cloud memory has a function of storing programs, data, and the like, as in the storage medium 12.

The processing circuit 11 controls the operation of each of the PCSs 7 and the connection switching circuit 8 to control the electrical connection state of each of the power storage facilities 3 with respect to the power grid 2 (the interconnection state of each of the power storage facilities 3 with the power grid 2). As a result, the exchange of the electric power of each of the power storage facilities 3 through the power grid 2 is controlled. In addition, the processing circuit 11 controls the operation of each of the PCSs 7 and the connection switching circuit 8 to control the electrical connection state of each of the power storage facilities 3 with respect to the other power storage facilities 3 in the power storage system 1. As a result,' the exchange of electric power between the plurality of power storage facilities 3 is controlled. Therefore, the processing circuit 11 controls charge, discharge, and the like of each of the power storage facilities 3 by controlling the operation of each of the PCSs 7 and the connection switching circuit 8.

For example, the operation of the connection switching circuit 8 is controlled by the processing circuit 11, whereby each of the power storage facilities 3 is switched between a state in which electric power is input and a state in which electric power is output. In each of the power storage facilities 3, in a state where electric power is input, the operation of the corresponding one of the PCS 7 is controlled by the processing circuit 11, so that the magnitude of the charge current, which is a current to be input, or the like is adjusted. In each of the power storage facilities 3, in a state where the electric power is output, the operation of the corresponding one of the PCS 7 is controlled by the processing circuit 11, so that the magnitude of the discharge current, which is the current to be output, or the like is adjusted.

The processing circuit 11 acquires a measurement result by each of the measurement circuits 6. Therefore, the processing circuit 11 acquires the measurement results of the current and the voltage for each of the power storage facilities 3. Then, the processing circuit 11 controls the operations of the PCSs 7 and the connection switching circuit 8 based on the measurement results of the current, the voltage, and the like for each of the power storage facilities 3, and controls charge, discharge, and the like of each of the power storage facilities 3. For example, the processing circuit 11 calculates the temporal change in current, the temporal change in voltage, and the like from the measurement result by the corresponding one of the measurement circuits 6 for each of the power storage facilities 3. Then, the processing circuit 11 controls charge, discharge, and the like of each of the power storage facilities 3 based on a temporal change in current, a temporal change in voltage, and the like.

For each of the power storage facilities 3, the processing circuit 11 calculates the real time SOC value and the temporal change (time history) in the SOC value using the measurement result of the current and the voltage in the corresponding one of the measurement circuits 6. The SOC value of each of the power storage facilities 3 is calculated using any of the methods described above. The processing circuit 11 controls the operations of the PCSs 7 and the connection switching circuit 8 based on the calculation results of the real time SOC value, the temporal change in the SOC value, and the like for each of the power storage facilities 3, and controls charge, discharge, and the like of each of the power storage facilities 3.

In an example, the power storage system 1 is provided with a user interface (not shown). In this case, the user interface receives an operation or the like related to the operation of the power storage system 1 from the user or the like of the operation device 10 and the power storage system 1. Therefore, the user interface includes any of a button, a mouse, a touch panel, a keyboard, and the like as an operating unit to which an operation is input by the user or the like. The user interface includes a notifier that makes notification of information related to the operation of power storage system 1. The notifier makes notification of information by any of screen display, transmission of sound, and the like. Note that the user interface may be integrated with the processing device constituting the operation device 10, or may be provided separately from the processing device constituting the operation device 10.

Hereinafter, processing performed by the processing circuit 11 or the like of the operation device 10 in the operation of the power storage system 1 will be described. The processing circuit 11 executes the operation program 16 to perform the following processing. In the present approach, in the operation of the power storage system 1, the processing circuit 11 or the like groups the plurality of power storage facilities 3 into a plurality of groups Y. One or more power storage facilities 3 belong to each of the plurality of grouped groups Y. Each of the plurality of power storage facilities 3 belongs to only one of the plurality of groups Y. The number of groups Y into which the power storage facilities 3 are grouped is preferably three or more. The number of power storage facilities 3 belonging to the group Y may be the same between the plurality of groups Y, or may be different between the plurality of groups Y. However, it is preferable that the number of power storage facilities 3 belonging to a groups Y is the same between the plurality of groups Y grouped.

In addition, the processing circuit 11 or the like sets a plurality of SOC ranges X shifted from each other as an option of the operation SOC range in which each of the plurality of power storage facilities 3 is operated. The plurality of SOC ranges X are set as an option of the operation SOC range of each of the plurality of groups Y grouped as described above. The number of set SOC ranges X is the number of grouped groups Y or more. The number of the SOC ranges X may be the same as or larger than the number of the groups Y. It is preferable that the plurality of power storage facilities 3 is grouped into three or more groups Y, and three or more SOC ranges X to be the option of the operation SOC range are set.

In each of the plurality of set SOC ranges X, a median SOC value ηc, an upper limit SOC value ηu, and a lower limit SOC value ηl are defined. In each of the SOC ranges X, the upper limit SOC value ηu is the upper limit of the SOC range, and the lower limit SOC value ηl is the lower limit of the SOC range. In each of the SOC ranges X, the median SOC value ηc is the center of the SOC range, and the median SOC value ηc corresponds to an addition average value of the upper limit SOC value ηu and the lower limit SOC value ηl. The processing circuit 11 or the like sets the SOC range X so as to be in a state where between the plurality of SOC ranges X, the median SOC values ηc are different, the upper limit SOC values ηu are different, and the lower limit SOC values ηl are different.

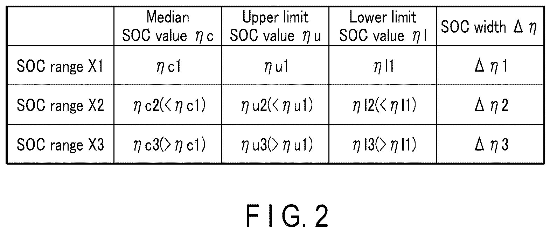

FIG. 2 illustrates an example of a plurality of SOC ranges X set by the processing circuit 11 or the like of the operation device 10 in the approach and the like. In an example of FIG. 2, three SOC ranges X1 to X3 are set as an option of the operation SOC range of each of the plurality of groups Y. The median SOC value ηc2 of the SOC range X2 is lower than the median SOC value ηc1 of the SOC range X1, and the median SOC value ηc3 of the SOC range X3 is higher than the median SOC value ηc1 of the SOC range X1. The upper limit SOC value ηu2 of the SOC range X2 is lower than the upper limit SOC value ηu1 of the SOC range X1, and the upper limit SOC value ηu3 of the SOC range X3 is higher than the upper limit SOC value ηu1 of the SOC range X1. The lower limit SOC value ηl2 of the SOC range X2 is lower than the lower limit SOC value ηl1 of the SOC range X1, and the lower limit SOC value ηl3 of the SOC range X3 is higher than the lower limit SOC value ηl1 of the SOC range X1.

Since the SOC ranges X1 to X3 are set as described above, the SOC ranges X1 to X3 are shifted from each other in an example of FIG. 2. In an example of FIG. 2, the SOC range X3 is a highest SOC range Xmax highest among the set SOC ranges X1 to X3. The SOC range X2 is a lowest SOC range Xmin lowest among the set SOC ranges X1 to X3.

An SOC width Δη corresponding to a width from the upper limit SOC value ηu to the lower limit SOC value ηl is defined in each of the SOC ranges X set as the option of the operation SOC range. In an example of FIG. 2, an SOC width Δη1 of the SOC range X1, an SOC width Δη2 of the SOC range X2, and an SOC width Δη3 of the SOC range X3 are defined. In the setting of the SOC range X, the SOC widths Δη may be the same between the plurality of SOC ranges X, or the SOC widths Δη may be different between the plurality of SOC ranges X.

Depending on a usage mode of the power storage system 1, each of the power storage facilities 3 may be charged and discharged in an SOC range whose SOC width is relatively small, such as a range whose SOC width is 50% or less. In such a case, the SOC width Δη is set to a relatively small value, for example, a value from 10% to 50% in each of the plurality of SOC ranges X to be the option of the operation SOC range. In an example, in each SOC range X, the SOC width Δη is set to any value from 25% to 35%.

In a preferred example, the processing circuit 11 or the like sets the SOC width Δη to be the same between the plurality of SOC ranges X. In this example, when the SOC ranges X1 to X3 are set as in an example of FIG. 2, the SOC widths Δη1 to Δη3 are identical to each other.

In another preferable example, the processing circuit 11 or the like sets the SOC width Δη to be larger for a lower SOC range among the plurality of SOC ranges X. In this example, when the SOC ranges X1 to X3 are set as in an example of FIG. 2, the SOC width Δη1 is larger than the SOC width Δη3, and the SOC width Δη2 is larger than the SOC width Δη1.

In a preferred example, a first SOC range Xa and a second SOC range Xb are set as the plurality of SOC ranges X to be the option of the operation SOC range, and a median SOC value ηcb of the second SOC range Xb is higher than an upper limit SOC value ηua of the first SOC range Xa. In another preferable example, the first SOC range Xa and a third SOC range Xc are set as the plurality of SOC ranges X to be the option of the operation SOC range, and a median SOC value ηcc of the third SOC range Xc is lower than a lower limit SOC value ηla of the first SOC range Xa. More preferably, both the second SOC range Xb and the third SOC range Xc are set as the plurality of SOC ranges X in addition to the first SOC range Xa.

For example, it is assumed that the SOC ranges X1 to X3 are set as in an example of FIG. 2. In this case, the median SOC value ηc3 of the SOC range X3 is preferably higher than the upper limit SOC value ηu1 of the SOC range X1. The median SOC value ηc2 of the SOC range X2 is preferably lower than the lower limit SOC value ηl1 of the SOC range X1. More preferably, the median SOC value ηc3 is higher than the upper limit SOC value ηu1, and the median SOC value ηc2 is lower than the lower limit SOC value nl1.

In a preferred example, an upper limit SOC value ηumax is set to any SOC value from 95% to 100% in the highest SOC range Xmax highest among the plurality of SOC ranges X to be the option of the operation SOC range. In another preferable example, a lower limit SOC value ηlmin is set to any SOC value from 0% to 5% in the lowest SOC range Xmin lowest among the plurality of SOC ranges X. More preferably, the upper limit SOC value ηumax in the highest SOC range Xmax is set to any SOC value from 95% to 100%, and the lower limit SOC value ηlmin in the lowest SOC range Xmin is set to any one of the SOC values from 0% to 5%.

For example, it is assumed that the SOC ranges X1 to X3 are set as in an example of FIG. 2. In this case, the upper limit SOC value ηu3 of the SOC range X3 to be the highest SOC range Xmax is preferably set to any SOC value from 95% to 100%. The lower limit SOC value ηl2 in the SOC range X2 to be the lowest SOC range Xmin is preferably set to any SOC value from 0% to 5%. More preferably, the upper limit SOC value ηu3 is set to any SOC value from 95% to 100%, and the lower limit SOC value ηl2 is set to any SOC value from 0% to 5%.

In the operation of the power storage system 1, the processing circuit 11 or the like selects (allocates) one of the plurality of SOC ranges X set as described above as the operation SOC range for each of the plurality of grouped groups Y. At this time, the SOC range X to be the operation SOC range is selected for each of the plurality of groups Y so as to be in a state where the SOC ranges X selected are different between the plurality of groups Y.

Then, the processing circuit 11 or the like operates the power storage facility 3 belonging to each of the plurality of groups Y with the SOC range X selected as the operation SOC range. Therefore, in each of the plurality of groups Y, the charge and discharge of each of the power storage facilities 3 belonging to this group Y are controlled in a state in which the SOC value of the power storage facility 3 falls within the SOC range X selected as the operation SOC range. In each of the groups Y, the SOC value of the power storage facility 3 that is not charged or discharged is kept at any SOC value in the SOC range X selected as the operation SOC range.

For example, as in an example of FIG. 2, it is assumed that the SOC ranges X1 to X3 are set as an option of the operation SOC range. In this case, for the group Y in which the SOC range X1 is selected as the operation SOC range, the processing circuit 11 or the like charges the power storage facility 3 belonging to the group Y in a state in which the SOC value of the power storage facility 3 does not exceed the upper limit SOC value ηu1 of the SOC range X1. Then, for the group Y in which the SOC range X1 is selected as the operation SOC range, the processing circuit 11 or the like discharges the power storage facility 3 belonging to the group Y in a state in which the SOC value of the power storage facility 3 does not fall below the lower limit SOC value ηl1 of the SOC range X1. For the group Y in which the SOC range X1 is selected as the operation SOC range, the processing circuit 11 or the like keeps the SOC value of the power storage facility 3 that is not charged or discharged at any SOC value from the lower limit SOC value ηl1 to the upper limit SOC value ηu1 of the SOC range X1.

In the operation of the power storage system 1, the processing circuit 11 or the like sequentially switches the SOC range X selected as the operation SOC range between the plurality of SOC ranges X set as an option for each of the plurality of groups Y. As a result, in each of the plurality of groups Y, the SOC range X to be the operation SOC range is rotated between the plurality of SOC ranges X. At this time, the SOC range X selected as the operation SOC range for each of the plurality of groups Y is sequentially switched so as to be in a state in which the SOC ranges X selected are different between the plurality of groups Y.

In each of the plurality of groups Y, as long as the SOC range X selected as the operation SOC range is sequentially switched and the SOC range X selected (allocated) in real time is different from that of the other groups Y, the order of selection as the operation SOC range and the like is not particularly limited. In addition, in each of the groups Y, each of the plurality of SOC ranges X to be the option may be periodically selected as the operation SOC range, or may be aperiodically selected as the operation SOC range.

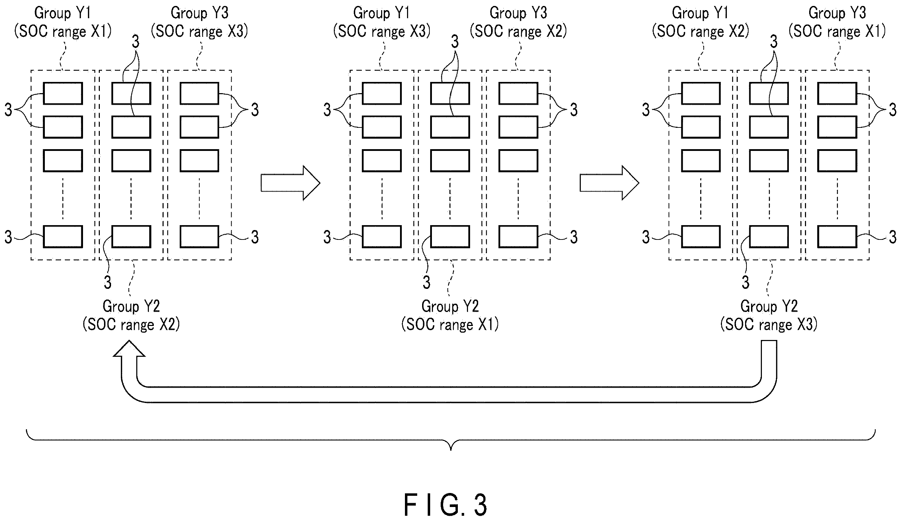

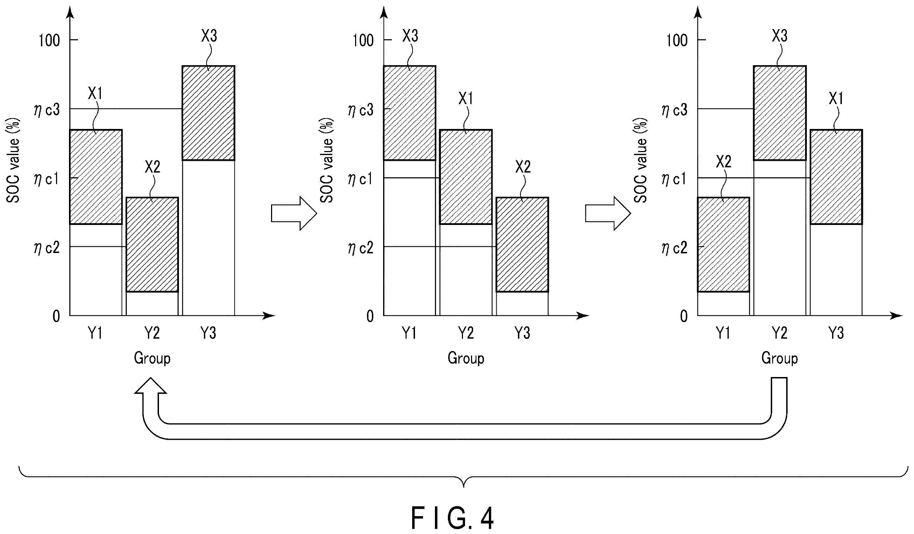

FIG. 3 illustrates an example of a switching process of switching the SOC range X selected as the operation SOC range for each of the plurality of groups Y, the switching process being performed by the processing circuit 11 or the like of the operation device 10 in the approach or the like. FIG. 4 illustrates a temporal change in the SOC range X selected as the operation SOC range for each of the plurality of groups Y in the switching process of an example of FIG. 3. In FIG. 4, three graphs are illustrated, and in each of the three graphs, the abscissa axis indicates the group Y to be grouped, and the ordinate axis indicates the SOC value. In FIG. 4, the SOC range X selected as the operation SOC range is indicated by hatching.

In an example of FIGS. 3 and 4, the plurality of power storage facilities 3 is grouped into three groups Y1 to Y3. As in an example of FIG. 2, the SOC ranges X1 to X3 are set as an option of the operation SOC range. In an example of FIGS. 3 and 4, for the power storage facility 3 belonging to the group Y1, the operation SOC range is switched in the order of the SOC range X1, the SOC range X3, the SOC range X2, the SOC range X1,.... For the power storage facility 3 belonging to the group Y2, the operation SOC range is switched in the order of the SOC range X2, the SOC range X1, the SOC range X3, the SOC range X2,..., and for the power storage facility 3 belonging to the group Y3, the operation SOC range is switched in the order of the SOC range X3, the SOC range X2, the SOC range X1, the SOC range X3,....

Therefore, in an example of FIGS. 3 and 4, the SOC range to be selected as the operation SOC range is switched for each of the plurality of groups Y1 to Y3 in a selection pattern in which all of the plurality of SOC ranges X1 to X3 to be the option are sequentially selected as the operation SOC range. In each of the groups Y1 to Y3, each of the plurality of SOC ranges X1 to X3 to be the option is periodically selected as the operation SOC range, and the number of times of selection as the operation SOC range is equal between the plurality of SOC ranges X1 to X3.

In the approach and the like, in each of the plurality of groups Y, each of the plurality of SOC ranges X to be the option may be aperiodically selected as the operation SOC range, and the number of times of selection as the operation SOC range may be unequal between the plurality of SOC ranges X. Further, in the approach and the like, for each of the plurality of groups Y, the SOC range X to be selected as the operation SOC range may be switched in a selection pattern (allocation pattern) in which only part (some) of the plurality of SOC ranges X to be the option are sequentially selected as the operation SOC range. In this case, in each of the plurality of groups Y, the SOC range X to be selected as the operation SOC range is sequentially switched, but part (some) of the optional SOC ranges X to be the option are not selected as the operation SOC range.

In an example, as in an example of FIGS. 3 and 4, the plurality of power storage facilities 3 is grouped into three groups Y1 to Y3, and three SOC ranges X1 to X3 are set as an option of the operation SOC range. For the group Y1, the operation SOC range is switched in the order of the SOC range X1, the SOC range X3, the SOC range X1, the SOC range X2, the SOC range X1,..., for the group Y2, the operation SOC range is switched in the order of the SOC range X2, the SOC range X1, the SOC range X2, the SOC range X3, the SOC range X2,..., and for the group Y3, the operation SOC range is switched in the order of the SOC range X3, the SOC range X2, the SOC range X3, the SOC range X1, the SOC range X3,....

Therefore, even in this example, the SOC range to be selected as the operation SOC range is switched for each of the plurality of groups Y1 to Y3 in the selection pattern in which all of the plurality of SOC ranges X1 to X3 to be the option are sequentially selected as the operation SOC ranges. However, in this example, in the group Y1, the number of times the SOC range X1 is selected as the operation SOC range is larger than the number of times each of the SOC ranges X2 and X3 is selected as the operation SOC range. In the group Y2, the number of times that the SOC range X2 is selected as the operation SOC range is larger than the number of times that each of the SOC ranges X1 and X3 is selected as the operation SOC range, and in the group Y3, the number of times that the SOC range X3 is selected as the operation SOC range is larger than the number of times that each of the SOC ranges X1 and X2 is selected as the operation SOC range.

In another example, as in an example of FIGS. 3 and 4, the plurality of power storage facilities 3 is grouped into three groups Y1 to Y3, and three SOC ranges X1 to X3 are set as an option of the operation SOC range. For the group Y1, the operation SOC range is switched in the order of the SOC range X1, the SOC range X3, the SOC range X1, the SOC ranges X3,..., for the group Y2, the operation SOC range is switched in the order of the SOC range X2, the SOC range X1, the SOC range X2, the SOC range X1,..., and for the group Y3, the operation SOC range is switched in the order of the SOC range X3, the SOC range X2, the SOC range X3, the SOC range X2,....

Therefore, in this example, the SOC range to be selected as the operation SOC range is switched for each of the plurality of groups Y1 to Y3 in a selection pattern in which only part (some) of the plurality of SOC ranges X1 to X3 to be the option are sequentially selected as the operation SOC range. That is, in the group Y1, only the SOC ranges X1 and X3 are selected as the operation SOC range, and the SOC range X2 is not selected as the operation SOC range. Similarly, in the group Y2, only the SOC ranges X1 and X2 are selected as the operation SOC range, and the SOC range X3 is not selected as the operation SOC range. In the group Y3, only the SOC ranges X2 and X3 are selected as the operation SOC range, and the SOC range X1 is not selected as the operation SOC range.

In any of the examples described above, the SOC range X to be selected as the operation SOC range is selected and switched for each of the plurality of groups Y so as to be in a state where the SOC ranges X selected are different between the plurality of groups Y. However, in a preferred example of the approach, as in an example of FIGS. 3 and 4, the SOC range X to be selected as the operation SOC range is switched for each of the plurality of groups Y in a selection pattern in which all of the plurality of SOC ranges X to be the option are sequentially selected as the operation SOC range. In a more preferable example, as in the examples of FIGS. 3 and 4, in each of the plurality of groups Y, all of the plurality of SOC ranges X to be the option are sequentially selected as the operation SOC ranges, and the number of times of selection as the operation SOC ranges is equal between the plurality of SOC ranges X to be the option.

When the number of SOC ranges X to be the option is larger than the number of groups Y to be grouped, the SOC range X to be selected as the operation SOC range is selected and switched for each of the plurality of groups Y in the same manner as in any one of the examples described above. That is, the SOC range X to be selected as the operation SOC range is selected and switched for each of the plurality of groups Y so as to be in a state where the SOC ranges X selected are different between the plurality of groups Y.

In an example, the plurality of power storage facilities 3 are grouped into three groups Y1 to Y3, and an SOC range X4 shifted from any of the SOC ranges X1 to X3 is set as an option of the operation SOC range in addition to the SOC ranges X1 to X3 described above. For the group Y1, the operation SOC range is switched in the order of the SOC range X1, the SOC range X2, the SOC range X3, the SOC range X4, the SOC range X1,..., for the group Y2, the operation SOC range is switched in the order of the SOC range X2, the SOC range X3, the SOC range X4, the SOC range X1, the SOC range X2,..., and for the group Y3, the operation SOC range is switched in the order of the SOC range X3, the SOC range X4, the SOC range X1, the SOC range X2, the SOC range X3, ....

In addition, for the median SOC value ηc of the SOC range X selected in real time as the operation SOC range, an addition average value ηcave in the plurality of grouped groups Y is defined. In a preferred example, the processing circuit 11 or the like selects and switches the SOC range X to be the operation SOC range for each of the plurality of groups Y so as to be in a state where the addition average value ηcave of the median SOC values ηc of the SOC ranges X selected in real time is from 45% to 55%. For this reason, in this example, in the state where the power storage system 1 is operated, at any time point, the addition average value ηcave of the median SOC values ηc of the plurality of SOC ranges X selected as the operation SOC ranges is from 45% to 55%.

For example, as in an example of FIGS. 3 and 4, it is assumed that the SOC range selected as the operation SOC range is switched in each of the groups Y1 to Y3. In this case, at any time point, the addition average value ηcave of the median SOC values ηc in the SOC ranges selected in real time in the groups Y1 to Y3 is the value (ηc1 + ηc2 + ηc3)/3. That is, in each of the period during which the SOC range X1 is in the operation SOC range in the group Y1, the period during which the SOC range X2 is in the operation SOC range in the group Y1, and the period during which the SOC range X3 is in the operation SOC range in the group Y1, the addition average value ηcave is the value (ηc1 + ηc2 + ηc3)/3. As in an example of FIGS. 3 and 4, when the SOC ranges to be the operation SOC ranges is switched in each of the groups Y1 to Y3, the SOC ranges X1 to X3 to be the option are preferably set in a state where the value (ηc1 + ηc2 + ηc3)/3 is from 45% to 55%.

Further, in the approach, the processing circuit 11 or the like switches the SOC range X to be selected as the operation SOC range for each of the plurality of groups Y so as to be in a state in which the timing at which the SOC range X to be the operation SOC range is switched is synchronized or substantially synchronized between the plurality of groups Y. In an example, the processing circuit 11 or the like calculates an elapsed period T from a time point when the SOC range X to be the operation SOC range in the plurality of grouped groups Y is switched at the previous time. Then, the processing circuit 11 or the like switches the SOC range X to be the operation SOC range for each of the groups Y based on the fact that the elapsed period T is a prescribed period Tref or more. Therefore, the processing circuit 11 or the like switches the SOC range X to be the operation SOC range for each of the plurality of groups in response to the prescribed period Tref or more having elapsed from the previous switching time point. The switching of the SOC range X to be the operation SOC range based on the time information such as the elapsed period T is suitable, for example, when the operation of the power storage facility 3 is constant throughout the year. The prescribed period Tref is set to an appropriate value in accordance with the strength of the operation of the power storage facility 3. For example, the prescribed period Tref is set to a shorter period (for example, one month or the like) in a case where the input/output is large and charging and discharging are frequently repeated than in a case where the input/output is small and the frequency of charging and discharging is also small. Then, the prescribed period Tref is set to a longer period (for example, 3 months or the like) in a case where the input/output is small and the frequency of charging and discharging is also small than in a case where charging and discharging are frequently repeated with large input and output. When the SOC range X selected as the operation SOC range in the group Y is not switched even once, the elapsed period from the time point of starting the operation of the power storage system 1 is used as the elapsed period T.

In another example, the processing circuit 11 or the like calculates an integrated value P from the time of the previous switching of the SOC range X to be the operation SOC range, for the amount of electric power input to and output from the plurality of entire power storage facilities 3. In this case, the integrated value of the input electric power (charge electric power) and the integrated value of the output electric power (discharge electric power) are calculated for each power storage facility 3 starting from the time of the previous switching, and the sum of the integrated value of the input electric power and the integrated value of the output electric power is calculated as the integrated value of the amount of electric power input to and output from one power storage facility 3. The integrated value of the input electric power and the output electric power in each of the power storage facilities 3 is calculated based on the temporal change in the current in the power storage facility 3 and the temporal change in the voltage in the power storage facility 3. Then, the integrated value P of the amount of electric power is calculated as a total value of the integrated values of the amounts of electric power calculated for respective power storage facilities 3 of all of the plurality of power storage facilities 3. The switching of the SOC range X to be the operation SOC range based on the integrated value of the amount of electric power is suitable, for example, when the operation of the power storage facility 3 greatly changes every season or every month.

In this example, the processing circuit 11 or the like switches the SOC range X to be the operation SOC range for each of the groups Y based on the fact that the integrated value P of the amount of electric power is a prescribed amount Pref of electric power or more. Therefore, the processing circuit 11 or the like switches the SOC range X to be the operation SOC range for each of the plurality of groups in response to the integrated value P of the amount of electric power input to and output from the plurality of entire power storage facilities 3 from the previous switching time point being the prescribed amount Pref of electric power or more. When the SOC range X selected as the operation SOC range in the group Y is not switched even once, the integrated value from the time point of starting the operation of the power storage system 1 for the amount of electric power input to and output from the plurality of entire power storage facilities 3 is used as the integrated value P of the amount of electric power.

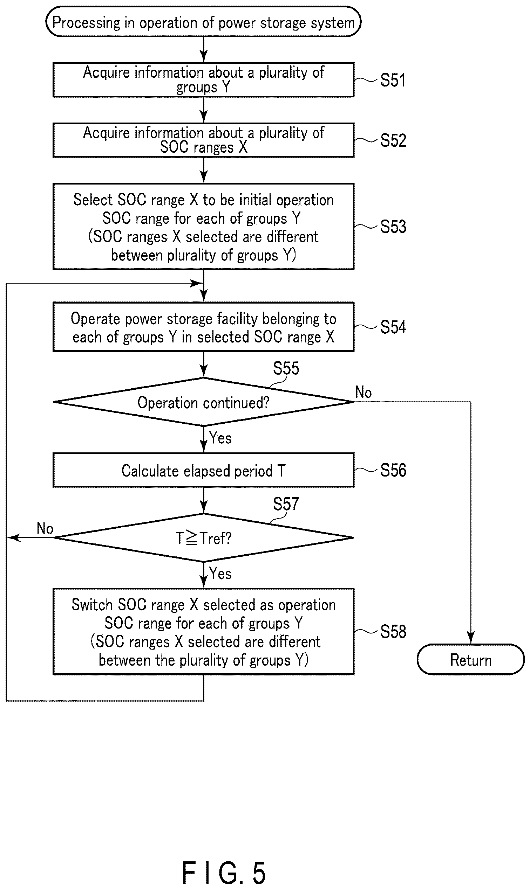

FIG. 5 illustrates an example of processing in the operation of the power storage system 1 performed by the processing circuit 11 or the like of the operation device 10 in the approach and the like. When the processing of an example of FIG. 5 is started, the processing circuit 11 or the like acquire information about a plurality of groups Y to be grouped (S51). As a result, information about how the plurality of power storage facilities 3 is grouped, identifiers of the power storage facilities 3 belonging to each of the plurality of groups Y, and the like are acquired by the processing circuit 11 or the like. Then, the processing circuit 11 or the like acquires information about a plurality of SOC ranges X to be the option of the operation SOC range of each of the plurality of groups Y (S52). The plurality of SOC ranges X is set in a state of being shifted from each other, and is set in the same manner as any of the above-described examples.

Then, the processing circuit 11 or the like selects the SOC range X to be the first operation SOC range from the plurality of SOC ranges X for each of the plurality of groups Y (S53). At this time, the SOC range X to be the operation SOC range is selected for each of the groups Y so as to be in a state where the SOC ranges X selected are different between the plurality of groups Y. Then, the processing circuit 11 or the like operates the power storage facility 3 belonging to each of the plurality of groups Y in the selected SOC range X (S54). At this time, for example, the processing circuit 11 or the like controls, for each of the plurality of groups Y, charge and discharge of each of the power storage facilities 3 belonging to this group Y so as to be in a state in which the SOC value of the power storage facility 3 falls within the SOC range X selected as the operation SOC range.

When the operation of the power storage system 1 is continued (S55-Yes), the processing circuit 11 or the like calculates the elapsed period T from the time point of starting the operation of the power storage system 1 or from the previous switching time point (S56). Then, the processing circuit 11 or the like determines whether the calculated elapsed period T is the prescribed period Tref or more (S57). When the elapsed period T is shorter than the prescribed period Tref (S57-No), the process returns to S54, and the processing circuit 11 or the like sequentially performs the processing of S54 and subsequent steps. As a result, the processing circuit 11 or the like continues, for each of the plurality of groups Y, the operation of the power storage facility 3 belonging to this group Y in the SOC range X selected as the operation SOC range in real time.

On the other hand, when the elapsed period T is the prescribed period Tref or more (Yes in S57), the processing circuit 11 or the like switches SOC range X selected as the operation SOC range for each of the plurality of groups Y (S58). At this time, the processing circuit 11 or the like switches the SOC range X selected as the operation SOC range for each of the groups Y so as to be in a state where the SOC ranges X selected are different between the plurality of groups Y. Then, the process returns to S54, and the processing circuit 11 or the like operates, for each of the plurality of groups Y, the power storage facility 3 belonging to this group Y in the SOC range X newly selected as the operation SOC range.

In an example, the processing circuit 11 or the like calculates the integrated value P of the amount of electric power described above instead of the processing of S56 and S57. Then, the processing circuit 11 or the like determines whether the calculated integrated value P of the amount of electric power is the prescribed amount Pref of electric power or more. When the integrated value P of the amount of electric power is smaller than the prescribed amount Pref of electric power, the processing circuit 11 or the like continues, for each of the plurality of groups Y, the operation of the power storage facility 3 belonging this group Y in the SOC range X selected as the operation SOC range in real time. On the other hand, when the integrated value P of the amount of electric power is the prescribed amount Pref of electric power or more, the processing circuit 11 or the like switches the SOC range X selected as the operation SOC range for each of the plurality of groups Y. Then, the processing circuit 11 or the like operate, for each of the plurality of groups Y, the power storage facility 3 belonging this group Y in the SOC range X newly selected as the operation SOC range.

Here, in a usage mode in which the power storage facility 3 is charged and discharged in an SOC range whose SOC width is relatively small, such as a range whose SOC width is 50% or less, when the power storage facility 3 is repeatedly charged and discharged only in one specific SOC range, the progress of deterioration of the power storage facility 3 and the battery 5 used in the power storage facility 3 may be accelerated depending on the type of the electrode active material used for the battery 5 of the power storage facility 3. For example, in the power storage facility 3 including the battery 5 in which lithium iron phosphate (LFP) is used as the positive electrode active material, the progress of the deterioration of the power storage facility 3 and the battery 5 tends to be accelerated by charging and discharging the power storage facility 3 only in one SOC range whose SOC width is relatively small.

In the present approach, for the plurality of grouped groups Y, one of the plurality of SOC ranges X shifted from each other is selected as the operation SOC range, and the power storage facility 3 belonging to each of the plurality of groups Y is operated in the SOC range X selected as the operation SOC range. For each of the plurality of groups Y, the SOC range X selected as the operation SOC range is sequentially switched between the plurality of SOC ranges X. Therefore, even when each of the power storage facilities 3 is charged and discharged in an SOC range whose SOC width is relatively small, such as a range whose SOC width is 50% or less, each of the power storage facilities 3 is not continuously operated only in one specific SOC range X, and each of the power storage facilities 3 is charged, discharged, and the like by sequentially switching the SOC range X. That is, by sequentially switching the operation SOC range between the plurality of SOC ranges X, it is possible to effectively prevent each of the power storage facilities 3 from being operated only in a specific SOC range. As a result, even in the usage mode in which each of the plurality of power storage facilities 3 is charged and discharged in the SOC range whose SOC width is relatively small, the progress of deterioration of each of the power storage facilities 3 is appropriately reduced.

In the present approach, since the progress of the deterioration of each power storage facility 3 is reduced by sequentially switching the SOC range X to be the operation SOC range, it is not necessary to perform the recovery process of each power storage facility 3 by interrupting the operation of the power storage system 1 or the like. For example, in a usage mode in which each of the power storage facilities 3 is charged and discharged in the SOC range whose SOC width is relatively small, it is not necessary to perform the recovery process of each of the power storage facilities 3 by repeating the charge-and-discharge cycle between the SOC value 0% and the SOC value 100%. Since the operation of the power storage system 1 is not interrupted by the recovery process or the like, the power storage system 1 is appropriately operated.

In the present approach, the SOC range X to be the operation SOC range is selected for each of the plurality of groups Y so as to be in a state where the SOC ranges X selected are different between the plurality of groups Y. Then, the SOC range X selected as the operation SOC range is switched for each of the plurality of groups Y so as to be in a state in which the SOC ranges X selected are different between the plurality of groups Y. Therefore, at any time point, in the plurality of groups Y, the SOC ranges X selected as the operation SOC ranges are different from each other. This effectively prevents all the groups Y (all the power storage facilities 3) from being operated in the high SOC range, all the groups Y (all the power storage facilities 3) from being operated in the low SOC range, and the like. Therefore, the power storage system 1 is appropriately operated in a state where the charge reserve and the discharge reserve in the power storage system 1 are secured at any timing.

In the present approach, the plurality of SOC ranges X are set so as to be in a state in which between the plurality of SOC ranges X, the median SOC values ηc are different, the upper limit SOC values ηu are different, and the lower limit SOC values ηl are different. Therefore, the plurality of SOC ranges X shifted from each other is appropriately set as an option of the operation SOC range.

Further, in an example of the present approach, in a case where the addition average value ηcave in the plurality of groups Y is defined as described above for the median SOC value ηc of the SOC range X selected as the operation SOC range, the addition average value ηcave of the median SOC values ηc is from 45% to 55% at any time point. As a result, in the operation of the power storage system 1, it is possible to more effectively prevent all the groups Y (all the power storage facilities 3) from being operated in the high SOC range, all the groups Y (all the power storage facilities 3) from being operated in the low SOC range, and the like. Therefore, the charge reserve and the discharge reserve of the power storage system 1 are appropriately secured at any timing, and the power storage system 1 is further appropriately operated.

Further, in an example of the present approach, the SOC range X to be selected as the operation SOC range is switched for each of the plurality of groups Y in a selection pattern in which all of the plurality of SOC ranges X to be the option are sequentially selected as the operation SOC range. By performing such processing, each of the power storage facilities 3 is operated in all of the plurality of SOC ranges X set as option in a state where the SOC range X to be the operation SOC range is sequentially switched. As a result, since each of the power storage facilities 3 is operated in a wide SOC range, the progress of deterioration of each of the power storage facilities 3 is further appropriately reduced.

Further, in an example of the present approach, in each of the plurality of groups Y, all of the plurality of SOC ranges X to be the option are sequentially selected as the operation SOC range, and the number of times of selection as the operation SOC ranges is equal between the plurality of SOC ranges X to be the option. By performing such processing, in each of the power storage facilities 3, all of the plurality of SOC ranges X set as options are uniformly selected (allocated) as the operation SOC range. As a result, the progress of deterioration of each of the power storage facilities 3 is further appropriately reduced.

In an example of the present exemplary approach, in addition to the first SOC range Xa, at least one of the second SOC range Xb in which the median SOC value ηcb is higher than the upper limit SOC value ηua of the first SOC range Xa and the third SOC range Xc in which the median SOC value ηcc is lower than the lower limit SOC value ηla of the first SOC range Xa is set as the plurality of SOC ranges X. When the SOC range X is set in this manner, the operation SOC range is sequentially switched between the plurality of SOC ranges X for each of the plurality of groups Y, whereby each of the power storage facilities 3 is operated in a wide SOC range. As a result, the progress of deterioration of each of the power storage facilities 3 is further appropriately reduced.

In a more preferred example, both the second SOC range Xb and the third SOC range Xc are set as the plurality of SOC ranges X in addition to the first SOC range Xa. When the SOC range X is set in this manner, the operation SOC range is sequentially switched between the plurality of SOC ranges X for each of the plurality of groups Y, whereby each of the power storage facilities 3 is operated in a wider SOC range. As a result, the progress of deterioration of the power storage facility 3 and the battery 5 used in the power storage facility 3 is further appropriately reduced.

In an example of the present exemplary approach, the upper limit SOC value ηumax of the highest SOC range Xmax highest among the plurality of SOC ranges X is set to any SOC value from 95% to 100%. In this case, for each of the plurality of groups Y, by sequentially switching the operation SOC range between the plurality of SOC ranges X, each of the power storage facilities 3 is operated even in a range where the SOC value is 95% or more. As a result, since each of the power storage facilities 3 is operated in a wider SOC range, the progress of deterioration of the power storage facility 3 and the like is further appropriately reduced.

Further, in an example of the present approach, the lower limit SOC value ηlmin in the lowest SOC range Xmin lowest among the plurality of SOC ranges X is set to any SOC value from 0% to 5%. In this case, for each of the plurality of groups Y, by sequentially switching the operation SOC range between the plurality of SOC ranges X, each of the power storage facilities 3 is operated even in a range where the SOC value is 5% or less. As a result, since each of the power storage facilities 3 is operated in a wider SOC range, the progress of deterioration of the power storage facility 3 and the like is further appropriately reduced.

In a more preferred example, the upper limit SOC value ηumax in the highest SOC range Xmax is set to any SOC value from 95% to 100%, and the lower limit SOC value ηlmin in the lowest SOC range Xmin is set to any SOC value from 0% to 5%. In this case, for each of the plurality of groups Y, by sequentially switching the operation SOC range between the plurality of SOC ranges X, each of the power storage facilities 3 is operated in both the range where the SOC value is 95% or more and the range where the SOC value is 5% or less. As a result, since each of the power storage facilities 3 is operated in a wider SOC range, the progress of deterioration of the power storage facility 3 and the like is further appropriately reduced.

Further, in an example of the present approach, the SOC width Δη from the upper limit SOC value ηu to the lower limit SOC value ηl is the same between the plurality of SOC ranges X. In a case where each of the power storage facilities 3 is operated by sequentially switching the operation SOC range between the plurality of SOC ranges X, the progress of deterioration of the power storage facility 3 and the battery 5 used in the power storage facility 3 is further appropriately reduced by making the SOC widths Δη equal to each other in the plurality of SOC ranges X.

In an example of the present approach, the SOC width Δη from the upper limit SOC value ηu to the lower limit SOC value ηl increases in the lower SOC range in the plurality of SOC ranges X. In each of the power storage facilities 3, the voltage decreases as the SOC value decreases. Therefore, by increasing the SOC width Δη in the lower SOC range, the variation in the amount of electric power between the plurality of SOC ranges X when the power storage facility 3 is charged with the current of the same magnitude from the lower limit SOC value ηl to the upper limit SOC value ηu is reduced. Similarly, by increasing the SOC width Δη in the lower SOC range, the variation in the amount of electric power between the plurality of SOC ranges X when the power storage facility 3 is discharged with the current of the same magnitude from the upper limit SOC value ηu to the lower limit SOC value ηl is reduced.

Further, in the present approach, the SOC range X to be selected as the operation SOC range is switched for each of the plurality of groups Y so as to be in a state in which the timing at which the SOC range X to be the operation SOC range is switched is synchronized or substantially synchronized between the plurality of groups Y. As a result, at any time point, the SOC ranges X selected as the operation SOC ranges are different between the plurality of groups Y.

In addition, the following verification was performed as verification related to the above-described approach and the like. In the verification, the batteries were operated in three patterns of Comparative Example, Example 1, and Example 2. As the battery, a cylindrical battery cell having a diameter of 26 mm and a height of 650 mm was used. That is, a 26650 type cylindrical battery cell was used as a battery. As an electrode active material of a battery, lithium iron phosphate (LFP) was used as a positive electrode active material, and graphite that is a kind of carbonaceous material was used as a negative electrode active material.

In the battery used, the battery capacity in the initial state at the start of use was 2500 mAh. In the battery, the end-of-charge voltage was 3.6 V, and 3.6 V was set as a voltage corresponding a state where the SOC value was 100%. In the battery, the end-of-discharge voltage was 2.0 V, and 2.0 V was set as a voltage corresponding a state where the SOC value was 0%. The verification was performed at an environmental temperature of 25°C. In the verification, the real time SOC value of the battery was calculated in the same manner as the calculation of the SOC value of the power storage facility described above in the approach and the like.

In Comparative Example, only the charge-and-discharge cycle between the SOC value 35% and the SOC value 65% where the SOC width was 30% was repeated. In one cycle, the battery was charged at a charge rate of 2C from an SOC value 35% to an SOC value 65%, and the battery was discharged at a discharge rate of 2C from an SOC value 65% to an SOC value 35%. In Comparative Example, the battery was discharged to an SOC value of 0% at a discharge rate of 0.3C every 50 cycles. Then, the battery was charged from an SOC value of 0% to an SOC value of 35% at a charge rate of 0.3C, and then the next cycle was started.

In Example 1, an SOC range Xα between the lower limit SOC value 10% and the upper limit SOC value 40% where the SOC width is 30%, an SOC range Xβ between the lower limit SOC value 22.5% and the upper limit SOC value 52.5% where the SOC width is 30%, an SOC range Xγ between the lower limit SOC value 47.5% and the upper limit SOC value 77.5% where the SOC width is 30%, and an SOC range Xε between the lower limit SOC value 60% and the upper limit SOC value 90% where the SOC width is 30% were set. Then, one of the SOC ranges Xα, Xβ, Xγ, and Xε was selected as the operation SOC range, and the battery was operated.

In the operation of the battery, a charge-and-discharge cycle between the lower limit SOC value and the upper limit SOC value in the SOC range selected as the operation SOC range was performed. In one cycle, the battery was charged at a charge rate of 2C from the lower limit SOC value to the upper limit SOC value, and the battery was discharged at a discharge rate of 2C from the upper limit SOC value to the lower limit SOC value.

In Example 1, the SOC range selected as the operation SOC range is switched between the SOC ranges Xα, Xβ, Xγ, and Xε every 50 cycles. Then, the operation SOC range was switched every 50 cycles in the order of Xα → Xβ → Xγ → Xε → Xγ → Xβ → Xα, and the operation SOC range was repeatedly switched every 50 cycles in the above-described order. In Example 1, the battery was discharged to an SOC value of 0% at a discharge rate of 0.3C every 50 cycles. Then, the battery was charged from an SOC value of 0% to a lower limit SOC value of the next cycle at a charge rate of 0.3C, and then the next cycle was started.

Also in Example 2, four SOC ranges Xα, Xβ, Xγ, and Xε were set as in Example 1. Then, one of the SOC ranges Xα, Xβ, Xγ, and Xε was selected as the operation SOC range, and the battery was operated. Also in Example 2, in the operation of the battery, the charge-and-discharge cycle was performed between the lower limit SOC value and the upper limit SOC value in the SOC range selected as the operation SOC range. In one cycle, the battery was charged at a charge rate of 2C from the lower limit SOC value to the upper limit SOC value, and the battery was discharged at a discharge rate of 2C from the upper limit SOC value to the lower limit SOC value.

In Example 2, unlike Example 1, the SOC range to be selected as the operation SOC range is switched between the SOC ranges Xα, Xβ, Xγ, and Xε every 25 cycles. Then, the operation SOC range was switched every 25 cycles in the order of Xα → Xβ -> Xγ → Xε -+ Xγ → Xβ → Xα, and the operation SOC range was repeatedly switched every 25 cycles in the above-described order. In Example 2, the battery was discharged to an SOC value of 0% at a discharge rate of 0.3C every 25 cycles. Then, the battery was charged from an SOC value of 0% to a lower limit SOC value of the next cycle at a charge rate of 0.3C, and then the next cycle was started.

In each of Comparative Example, Example 1, and Example 2, the battery capacity of the battery was measured at each of a plurality of time points while operating the battery as described above. Then, at each time point when the battery capacity was measured, the capacity retention ratio of the battery capacity with respect to the battery capacity (2500 mAh) in the initial state was calculated, and the temporal change in the capacity retention ratio of the battery capacity was calculated. In the measurement of the battery capacity of the battery, the battery was charged up to an SOC value of 100% at a charge rate of 0.1 C. Then, the battery was discharged at a discharge rate of 0.1 C from the SOC value 100% to the SOC value 0%, and a discharge capacity from the SOC value 100% to the SOC value 0% was measured as a battery capacity of the battery.

In each of Comparative Example, Example 1, and Example 2, the cumulative value of the amount of discharge of the battery from the time of starting the operation of the battery (the time of starting the first cycle) was calculated at each time point when the battery capacity was measured. Then, at each time point when the battery capacity was measured, an equivalent cycle value was calculated as a value obtained by dividing the cumulative value of the amount of discharge of the battery by the battery capacity (2500 mAh) in the initial state. The equivalent cycle value corresponds to a value indicating how many cycles (how many times) the charge-and-discharge cycle is performed between the SOC value 0% and the SOC value 100% where the SOC width is 100%.

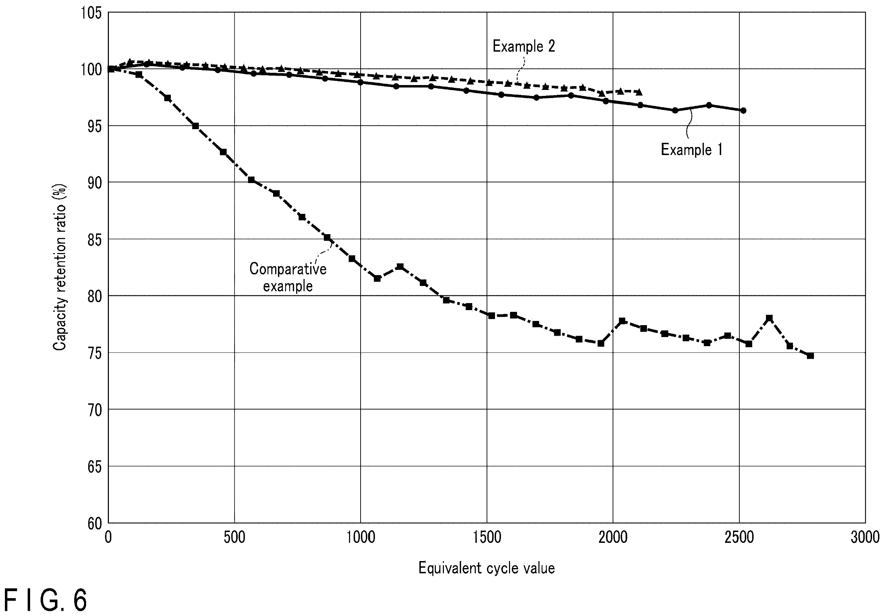

FIG. 6 shows temporal changes in the capacity retention ratio of the battery capacity in each of Comparative Example, Example 1, and Example 2 as verification results. In FIG. 6, the abscissa axis represents the equivalent cycle value described above, and the ordinate axis represents the capacity retention ratio of the battery capacity. In FIG. 6, the change in the capacity retention ratio in Example 1 is plotted by the solid line and circles, the change in the capacity retention ratio in Example 2 is plotted by the broken line and triangles, and the change in the capacity retention ratio in Comparative Example is plotted by the alternate long and short dash line and squares.

As shown in FIG. 6 and the like, in each of Example 1 and Example 2, even when the equivalent cycle value was 2000 or more, the capacity retention ratio of the battery capacity was maintained at 95% or more. On the other hand, in Comparative Example, when the equivalent cycle value was about 1000, the capacity retention ratio of the battery capacity fell below 85%. When the equivalent cycle value reached about 1500, the capacity retention ratio of the battery capacity fell below 80%.

From the above-described verification, it has been demonstrated that in a battery in which lithium iron phosphate is used as a positive electrode active material, the progress of deterioration of the battery is accelerated when charging and discharging are continued only in one SOC range whose SOC width is relatively small. In addition, it has been demonstrated that even when the SOC width of each of the plurality of SOC ranges is relatively small, the progress of deterioration of the battery is appropriately reduced by sequentially switching the SOC range selected as the operation SOC range between the plurality of SOC ranges shifted from each other.

In addition, from the above verification, it has been demonstrated that in a power storage facility including a battery in which lithium iron phosphate is used as a positive electrode active material, the progress of deterioration of the power storage facility is accelerated when charging and discharging are continued only in one SOC range whose SOC width is relatively small. In addition, it has been demonstrated that even when the SOC width of each of the plurality of SOC ranges is relatively small, the progress of the deterioration of the power storage facility is appropriately reduced by sequentially switching the SOC range selected as the operation SOC range between the plurality of SOC ranges shifted from each other.

In at least one approach or at least one example described above, one of the plurality of SOC ranges to be the option is selected as the operation SOC range for each of the plurality of groups so as to be in a state in which the SOC ranges selected are different between the plurality of groups, and the power storage facility belonging to each of the plurality of groups is operated in the SOC range selected as the operation SOC range. Then, the SOC range selected as the operation SOC range is sequentially switched between the plurality of SOC ranges for each of the plurality of groups so as to be in a state in which the SOC ranges selected are different between the plurality of groups. Accordingly, in a usage mode in which each of the plurality of power storage facilities is charged and discharged in an SOC range whose SOC width is relatively small, it is possible to provide an operation method, an operation device, and an operation program of the power storage system, and the power storage system in which the operation is appropriately performed while appropriately reducing the progress of deterioration of the power storage facility.

The present disclosure also encompasses the following approaches of an operation method, an operation device and an operation program of a power storage system, and the power storage system:
1. An operation method of a power storage system (1) including a plurality of power storage facilities (3), the operation method comprising:
   grouping the plurality of power storage facilities (3) into a plurality of groups (Y), and setting a plurality of SOC ranges (X) shifted from each other as an option of an operation SOC range of each of the plurality of groups (Y);
   selecting one of the plurality of SOC ranges (X) to be the option as the operation SOC range for each of the plurality of groups (Y) so as to be in a state in which the SOC ranges (X) selected are different between the plurality of groups (Y), and operating a power storage facility (3) belonging to each of the plurality of groups (Y) in an SOC range (X) selected as the operation SOC range; and
   sequentially switching, between the plurality of SOC ranges (X), an SOC range (X) selected as the operation SOC range for each of the plurality of groups (Y) so as to be in a state in which the SOC ranges (X) selected are different between the plurality of groups (Y).
2. The operation method according to clause 1, wherein the switching includes switching an SOC range (X) to be selected as the operation SOC range for each of the plurality of groups (Y) in a selection pattern in which all of the plurality of SOC ranges (X) to be the option are sequentially selected as the operation SOC range.
3. The operation method according to clause 1 or 2, wherein the setting includes setting the plurality of SOC ranges (X) to be the option so as to be in a state in which between the plurality of SOC ranges (X), median SOC values (ηc) are different, upper limit SOC values (ηu) are different, and lower limit SOC values (ηl) are different.
4. The operation method according to clause 3, wherein when an addition average value (ηcave) of the plurality of groups (Y) is defined for the median SOC value (ηc) in an SOC range (X) selected as the operation SOC range, an SOC range (X) to be the operation SOC range is selected and switched for each of the plurality of groups (Y) so as to be in a state where the addition average value (ηcave) is from 45% to 55%.
5. The operating method according to clause 3 or 4, wherein the setting includes setting a first SOC range (Xa) in setting of the plurality of SOC ranges (X), and setting at least one of a second SOC range (Xb) in which the median SOC value (ηcb) is higher than the upper limit SOC value (ηua) in the first SOC range (Xa) and a third SOC range (Xc) in which the median SOC value (ηcc) is lower than the lower limit SOC value (ηla) in the first SOC range (Xa).
6. The operation method according to any one of clauses 3 to 5, wherein the setting includes making an SOC width (Δη) from the upper limit SOC value (ηu) to the lower limit SOC value (ηl) same between the plurality of SOC ranges (X) in setting the plurality of SOC ranges (X).
7. The operation method according to any one of clauses 3 to 5, wherein in setting of the plurality of SOC ranges (X), the lower a SOC range is among the plurality of SOC ranges (X), the larger an SOC width (Δη) from the upper limit SOC value (ηu) to the lower limit SOC value (ηl) is made.
8. The operation method according to any one of clauses 3 to 7, wherein the setting includes at least one of setting the upper limit SOC value (ηumax) in a highest SOC range (Xmax) highest among the plurality of SOC ranges (X) to any SOC value from 95% to 100% and setting the lower limit SOC value (ηlmin) in a lowest SOC range (Xmin) lowest among the plurality of SOC ranges (X) to any SOC value from 0% to 5% in setting of the plurality of SOC ranges (X).
9. The operation method according to any one of clauses 1 to 8, wherein the switching includes switching an SOC range (X) to be selected as the operation SOC range for each of the plurality of groups (Y) so as to be in a state where a timing at which an SOC range (X) to be the operation SOC range is switched is synchronized between the plurality of groups (Y).
10. The operation method according to any one of clauses 1 to 9, wherein the grouping and the operating include grouping the plurality of power storage facilities (3) each including one or more batteries (5) in which lithium iron phosphate is used as a positive electrode active material into the plurality of groups (Y), and operating a power storage facility (3) belonging to each of the plurality of groups (Y) in an SOC range (X) selected as the operation SOC range.
11. An operation device (10) of a power storage system (1) including a plurality of power storage facilities (3), the operation device (10) comprising a processor configured to:
   group the plurality of power storage facilities (3) into a plurality of groups (Y), and set a plurality of SOC ranges (X) shifted from each other as an option of an operation SOC range of each of the plurality of groups (Y);
   select one of the plurality of SOC ranges (X) to be the option as the operation SOC range for each of the plurality of groups (Y) so as to be in a state in which the SOC ranges (X) selected are different between the plurality of groups (Y), and operate a power storage facility (3) belonging to each of the plurality of groups (Y) in an SOC range (X) selected as the operation SOC range; and
   sequentially switch, between the plurality of SOC ranges (X), an SOC range (X) selected as the operation SOC range for each of the plurality of groups (Y) so as to be in a state in which the SOC ranges (X) selected are different between the plurality of groups (Y).
12. A power storage system (1) comprising:
   the operation device (10) according to clause 11; and
   the plurality of power storage facilities (3) grouped into the plurality of groups (Y) by the processor of the operation device (10) and each operated, by the processor, in an SOC range (X) selected as the operation SOC range in a group (Y) to which this power storage facility (3) belongs.
13. The power storage system (1) according to clause 12, wherein
   each of the plurality of power storage facilities (3) includes one or more batteries (5), and
   in each of the plurality of power storage facilities (3), each of the one or more batteries (5) includes lithium iron phosphate as a positive electrode active material.
14. An operation program (16) of a power storage system (1) including a plurality of power storage facilities (3), the operation program (16) causing a computer to implement:
   grouping the plurality of power storage facilities (3) into a plurality of groups (Y), and setting a plurality of SOC ranges (X) shifted from each other as an option of an operation SOC range of each of the plurality of groups (Y);
   selecting one of the plurality of SOC ranges (X) to be the option as the operation SOC range for each of the plurality of groups (Y) so as to be in a state in which the SOC ranges (X) selected are different between the plurality of groups (Y), and operating a power storage facility (3) belonging to each of the plurality of groups (Y) in an SOC range (X) selected as the operation SOC range; and
   sequentially switching, between the plurality of SOC ranges (X), an SOC range (X) selected as the operation SOC range for each of the plurality of groups (Y) so as to be in a state in which the SOC ranges (X) selected are different between the plurality of groups (Y).

While certain approaches have been described, these approaches have been presented by way of example only, and are not intended to limit the scope of the inventions. Indeed, the novel approaches described herein may be embodied in a variety of other forms; furthermore, various omissions, substitutions and changes in the form of the approaches described herein may be made without departing from the spirit of the inventions. The accompanying claims and their equivalents are intended to cover such forms or modifications as would fall within the scope and spirit of the inventions.

## Claims

1. An operation method of a power storage system (1) including a plurality of power storage facilities (3), the operation method comprising:
grouping the plurality of power storage facilities (3) into a plurality of groups (Y), and setting a plurality of SOC ranges (X) shifted from each other as an option of an operation SOC range of each of the plurality of groups (Y);
selecting one of the plurality of SOC ranges (X) to be the option as the operation SOC range for each of the plurality of groups (Y) so as to be in a state in which the SOC ranges (X) selected are different between the plurality of groups (Y), and operating a power storage facility (3) belonging to each of the plurality of groups (Y) in an SOC range (X) selected as the operation SOC range; and
sequentially switching, between the plurality of SOC ranges (X), an SOC range (X) selected as the operation SOC range for each of the plurality of groups (Y) so as to be in a state in which the SOC ranges (X) selected are different between the plurality of groups (Y).

2. The operation method according to claim 1, wherein the switching includes switching an SOC range (X) to be selected as the operation SOC range for each of the plurality of groups (Y) in a selection pattern in which all of the plurality of SOC ranges (X) to be the option are sequentially selected as the operation SOC range.

3. The operation method according to claim 1 or 2, wherein the setting includes setting the plurality of SOC ranges (X) to be the option so as to be in a state in which between the plurality of SOC ranges (X), median SOC values (ηc) are different, upper limit SOC values (ηu) are different, and lower limit SOC values (ηl) are different.

4. The operation method according to claim 3, wherein when an addition average value (ηcave) of the plurality of groups (Y) is defined for the median SOC value (ηc) in an SOC range (X) selected as the operation SOC range, an SOC range (X) to be the operation SOC range is selected and switched for each of the plurality of groups (Y) so as to be in a state where the addition average value (ηcave) is from 45% to 55%.

5. The operating method according to claim 3 or 4, wherein the setting includes setting a first SOC range (Xa) in setting of the plurality of SOC ranges (X), and setting at least one of a second SOC range (Xb) in which the median SOC value (qcb) is higher than the upper limit SOC value (ηua) in the first SOC range (Xa) and a third SOC range (Xc) in which the median SOC value (ηcc) is lower than the lower limit SOC value (ηla) in the first SOC range (Xa).

6. The operation method according to any one of claims 3 to 5, wherein the setting includes making an SOC width (Δη) from the upper limit SOC value (ηu) to the lower limit SOC value (ηl) same between the plurality of SOC ranges (X) in setting the plurality of SOC ranges (X).

7. The operation method according to any one of claims 3 to 5, wherein in setting of the plurality of SOC ranges (X), the lower a SOC range is among the plurality of SOC ranges (X), the larger an SOC width (Δη) from the upper limit SOC value (ηu) to the lower limit SOC value (ηl) is made.

8. The operation method according to any one of claims 3 to 7, wherein the setting includes at least one of setting the upper limit SOC value (ηumax) in a highest SOC range (Xmax) highest among the plurality of SOC ranges (X) to any SOC value from 95% to 100% and setting the lower limit SOC value (ηlmin) in a lowest SOC range (Xmin) lowest among the plurality of SOC ranges (X) to any SOC value from 0% to 5% in setting of the plurality of SOC ranges (X).

9. The operation method according to any one of claims 1 to 8, wherein the switching includes switching an SOC range (X) to be selected as the operation SOC range for each of the plurality of groups (Y) so as to be in a state where a timing at which an SOC range (X) to be the operation SOC range is switched is synchronized between the plurality of groups (Y).

10. The operation method according to any one of claims 1 to 9, wherein the grouping and the operating include grouping the plurality of power storage facilities (3) each including one or more batteries (5) in which lithium iron phosphate is used as a positive electrode active material into the plurality of groups (Y), and operating a power storage facility (3) belonging to each of the plurality of groups (Y) in an SOC range (X) selected as the operation SOC range.

11. An operation device (10) of a power storage system (1) including a plurality of power storage facilities (3), the operation device (10) comprising a processor configured to:
group the plurality of power storage facilities (3) into a plurality of groups (Y), and set a plurality of SOC ranges (X) shifted from each other as an option of an operation SOC range of each of the plurality of groups (Y);
select one of the plurality of SOC ranges (X) to be the option as the operation SOC range for each of the plurality of groups (Y) so as to be in a state in which the SOC ranges (X) selected are different between the plurality of groups (Y), and operate a power storage facility (3) belonging to each of the plurality of groups (Y) in an SOC range (X) selected as the operation SOC range; and
sequentially switch, between the plurality of SOC ranges (X), an SOC range (X) selected as the operation SOC range for each of the plurality of groups (Y) so as to be in a state in which the SOC ranges (X) selected are different between the plurality of groups (Y).

12. A power storage system (1) comprising:
the operation device (10) according to claim 11; and
the plurality of power storage facilities (3) grouped into the plurality of groups (Y) by the processor of the operation device (10) and each operated, by the processor, in an SOC range (X) selected as the operation SOC range in a group (Y) to which this power storage facility (3) belongs.

13. The power storage system (1) according to claim 12, wherein
each of the plurality of power storage facilities (3) includes one or more batteries (5), and
in each of the plurality of power storage facilities (3), each of the one or more batteries (5) includes lithium iron phosphate as a positive electrode active material.

14. An operation program (16) of a power storage system (1) including a plurality of power storage facilities (3), the operation program (16) causing a computer to implement:
grouping the plurality of power storage facilities (3) into a plurality of groups (Y), and setting a plurality of SOC ranges (X) shifted from each other as an option of an operation SOC range of each of the plurality of groups (Y);
selecting one of the plurality of SOC ranges (X) to be the option as the operation SOC range for each of the plurality of groups (Y) so as to be in a state in which the SOC ranges (X) selected are different between the plurality of groups (Y), and operating a power storage facility (3) belonging to each of the plurality of groups (Y) in an SOC range (X) selected as the operation SOC range; and
sequentially switching, between the plurality of SOC ranges (X), an SOC range (X) selected as the operation SOC range for each of the plurality of groups (Y) so as to be in a state in which the SOC ranges (X) selected are different between the plurality of groups (Y).
